# EUROPÄISCHE PATENTANMELDUNG

(11) **EP 2 757 382 A2**
(43) Veröffentlichungstag der Anmeldung: **23.07.2014**
(21) Anmeldenummer: 13195361.4
(22) Anmeldetag: 02.12.2013
(51) Int. Cl.: G01R 15/18

(54) **Strommesseinrichtung und -Verfahren**

(30) Priorität: 17.01.2013 DE 102013200636
(71) Anmelder: SEMIKRON Elektronik GmbH & Co. KG, 90431 Nürnberg (DE)
(72) Erfinder: Mühlhöfer, Alexander, 90522 Oberasbach (DE)

(57) **Zusammenfassung**

Die Erfindung betrifft eine Strommesseinrichtung (1) umfassend:
-einen Kompensationsstromwandler (2) mit mindestens einer Kompensationswicklung (L2),
-eine Spannungserzeugungseinrichtung (R1), die dazu ausgebildet ist eine zur Höhe eines durch die mindestens eine Kompensationswicklung (L2) fließenden Kompensationsstroms (Ik) zumindest näherungsweise korrespondierende elektrische erste Spannung (U1) zu erzeugen,
-eine Kompensationsstromreduktionseinrichtung (7), die dazu ausgebildet ist, die erste Spannung (U1) mit einer Referenzspannung (Uref) zu vergleichen und falls die erste Spannung (U1) die Referenzspannung (Uref) übersteigt auf eine Leistungseinheit (6) derart einzuwirken, dass die Höhe des Kompensationsstroms (Ik) reduziert wird. Weiterhin betrifft die Erfindung Verfahren zum Betrieb einer Strommesseinrichtung (1).

Die Erfindung schafft eine Strommesseinrichtung (1) mit einem Kompensationsstromwandler (2) und ein Verfahren zum Betrieb einer Strommesseinrichtung mit einem Kompensationsstromwandler (2), die einen zuverlässigen Betrieb, insbesondere eines Leistungshalbleitermoduls (9), ermöglichen.

## Beschreibung

Die Erfindung betrifft eine Strommesseinrichtung. Weiterhin betrifft die Erfindung ein Verfahren zum Betrieb einer Strommesseinrichtung.

Bei aus dem Stand der Technik bekannten Leistungshalbleitermodulen sind im Allgemeinen auf einem Substrat Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor), oder in Form von Thyristoren vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden. Das Substrat ist in der Regel direkt oder indirekt mit einem Kühlkörper verbunden.

Zur Messung der Ströme werden dabei, insbesondere bei Leistungshalbleitermodulen, Kompensationsstromwandler eingesetzt. Ein techniküblicher Kompensationsstromwandler weist einen magnetisch leitfähigen Kern und mindestens eine um den Kern verlaufende Messwicklung und mindestens eine um den Kern verlaufende Kompensationswicklung, sowie eine Regeleinrichtung und eine von der Regeleinrichtung angesteuerte Leistungseinheit auf. Die mindestens eine Messwicklung erzeugt, wenn ein zu messender Strom durch die mindestens eine Messwicklung fließt, einen durch den Kern verlaufenden magnetischen Messfluss. Alternativ hierzu sind auch Kompensationsstromwandler bekannt, bei denen, anstatt der Verwendung mindestens einer Messwicklung zur Erzeugung des magnetischen Messflusses, der magnetisch leitfähige Kern um die elektrische Leitung angeordnet ist, durch den der zu messende Strom fließt. Die Leistungseinheit erzeugt einen durch die mindestens eine Kompensationswicklung fließenden Kompensationsstrom, wobei die Regeleinrichtung die Leistungseinheit derart ansteuert, dass ein beim Fließen des Kompensationsstroms von der mindestens einen Kompensationswicklung erzeugter, durch den Kern verlaufender, magnetischer Kompensationsfluss genauso groß ist aber in entgegengesetzte Richtung durch den Kern verläuft wie der magnetische Messfluss. Das Verhältnis des Kompensationsstroms Ik zum Messstrom Im wird bei Verwendung mindestens einer Messwicklung durch das Verhältnis der Anzahl der Windungen der mindestens einen Messwicklung zur Anzahl der Windungen der mindestens einen Kompensationswicklung bestimmt. Mittels eines elektrischen Messwiderstands, durch den der Kompensationsstrom fließt, wird eine zum Kompensationsstrom proportionale Messspannung als Ausgangsgröße erzeugt.

Die Leistungshalbleitermodule weisen zur Ansteuerung der Leitungshalbleiterschalter Treiber auf, die z.B. von einer Steuerung erzeugte Ein- und Ausschaltsignale in entsprechende Ansteuersignale für die Leitungshalbleiterschalter umsetzten. Der jeweilige Treiber ist dabei ausgangsseitig mit dem Steueranschluss (Basis, Gate) des im zugeordneten Leitungshalbleiterschalters elektrisch verbunden.

Weiterhin weisen Leistungshalbleitermodule im Allgemeinen zur Energieversorgung der Treiber und der Kompensationsstromwandler jeweilig eine Energieversorgungeinrichtung auf, die die Treiber und die Kompensationsstromwandler des jeweiligen Leistungshalbleitermoduls mit elektrischer Energie versorgt.

Wenn der vom Kompensationsstromwandler zu messende Strom, z.B. durch einen Fehler wie z.B. einen Kurzschluss sehr groß wird, wird der Kompensationsstrom sehr groß, was zu einer Zerstörung oder Beschädigung der Leistungseinheit des Kompensationsstromwandlers und/oder zu einer Überlastung der Energieversorgungeinrichtung führen kann. Insbesondere eine Überlastung der Energieversorgungeinrichtung kann dabei nachfolgend zu einem besonders hohen Schaden führen, da es bei einer Überlastung der Energieversorgungeinrichtung zu einem Ausfall der Treiber kommen kann, so dass die Leitungshalbleiterschalter nicht mehr ansteuerbar sind und folglich z.B. ein Gleich- -oder Wechselrichter, der z.B. mittels der Leistungshalbleitermodule aufgebaut ist, nicht mehr kontrollierbar ist.

Es ist dabei wünschenswert, dass wenn der vom Kompensationsstromwandler zu messende Strom, z.B. durch einen Fehler, wie z.B. einen Kurzschluss sehr groß wird und eine Zerstörung oder Beschädigung der Leistungseinheit des Kompensationsstromwandlers und/oder eine Überlastung der Energieversorgungeinrichtung droht, der Kompensationsstrom nicht z.B. von einer Sicherheitsschaltung abgeschaltet wird, da dann z.B. an eine Steuerung, die zur Steuerung der Leistungshalbleitermodule ausgebildet ist, fälschlicherweise eine Stromhöhe mit einem Wert von Null übermittelt wird, sondern dass die vom Kompensationsstromwandler ermittelte Stromhöhe bzw. der Kompensationsstrom nach wie vor einen hohen Wert annimmt, der aber nicht so hoch ist, dass dieser zu einer Zerstörung oder Beschädigung der Leistungseinheit oder einer Überlastung der Energieversorgungeinrichtung führt, so dass die Steuerung Gegenmaßnahmen ergreifen kann.

Es ist Aufgabe der Erfindung eine Strommesseinrichtung mit einem Kompensationsstromwandler und ein Verfahren zum Betrieb einer Strommesseinrichtung mit einem Kompensationsstromwandler zu schaffen, die einen zuverlässigen Betrieb, insbesondere eines Leistungshalbleitermoduls, ermöglichen.

Diese Aufgabe wird gelöst durch eine Strommesseinrichtung umfassend:
- einen Kompensationsstromwandler, der einen magnetisch leitfähigen Kern und mindestens eine um den Kern verlaufende Kompensationswicklung, sowie eine Regeleinrichtung und eine von der Regeleinrichtung angesteuerte Leistungseinheit aufweist, wobei ein zu messender Strom einen durch den Kern verlaufenden magnetischen Messfluss bewirkt, wobei die Leistungseinheit einen durch die mindestens eine Kompensationswicklung fließenden Kompensationsstrom erzeugt, wobei die Regeleinrichtung die Leistungseinheit derart ansteuert, dass ein beim Fließen des Kompensationsstroms von der mindestens einen Kompensationswicklung erzeugter, durch den Kern verlaufender, magnetischer Kompensationsfluss genauso groß ist aber in entgegengesetzte Richtung durch den Kern verläuft wie der magnetische Messfluss,
- eine Spannungserzeugungseinrichtung, die dazu ausgebildet ist eine zur Höhe des Kompensationsstroms zumindest näherungsweise korrespondierende elektrische erste Spannung zu erzeugen, und
- eine Kompensationsstromreduktionseinrichtung, die dazu ausgebildet ist, die erste Spannung mit einer Referenzspannung zu vergleichen und falls die erste Spannung die Referenzspannung übersteigt auf die Leistungseinheit derart einzuwirken, dass die Höhe des Kompensationsstroms reduziert wird.

Weiterhin wir diese Aufgabe gelöst durch ein Verfahren zum Betrieb einer Strommesseinrichtung,
- wobei die Strommesseinrichtung einen Kompensationsstromwandler, der einen magnetisch leitfähigen Kern und mindestens eine um den Kern gewickelte Kompensationswicklung, sowie eine Regeleinrichtung und eine von der Regeleinrichtung angesteuerte Leistungseinheit aufweist,
- wobei von einem zu messenden Strom, ein durch den Kern verlaufender magnetischer Messfluss bewirkt wird,
- wobei von der Leistungseinheit ein durch die mindestens eine Kompensationswicklung fließender Kompensationsstrom erzeugt wird,
- wobei die Leistungseinheit von der Regeleinrichtung derart ansteuert wird, dass ein beim Fließen des Kompensationsstroms von der mindestens einen Kompensationswicklung erzeugter, durch den Kern verlaufender, magnetischer Kompensationsfluss genauso groß ist aber in entgegengesetzte Richtung durch den Kern verläuft wie der magnetische Messfluss,
- wobei eine zur Höhe des Kompensationsstroms zumindest näherungsweise korrespondierende elektrische erste Spannung erzeugt wird,
- wobei die erste Spannung mit einer Referenzspannung verglichen wird und falls die erste Spannung die Referenzspannung übersteigt die Höhe des Kompensationsstroms reduziert wird.

Vorteilhafte Ausbildungen der Erfindung ergeben sich aus den abhängigen Ansprüchen.

Vorteilhafte Ausbildungen des Verfahrens ergeben sich analog zu vorteilhaften Ausbildungen der Strommesseinrichtung und umgekehrt.

Es erweist sich als vorteilhaft, wenn die Kompensationsstromreduktionseinrichtung dazu ausgebildet ist, die erste Spannung mit einer Referenzspannung zu vergleichen und falls die erste Spannung die Referenzspannung übersteigt auf die Leistungseinheit derart einzuwirken, dass die Höhe des Kompensationsstroms auf einen derartigen Wert reduziert wird, dass die erste Spannung der Referenzspannung entspricht. Hierdurch kann die maximale Höhe des Kompensationsstroms eingestellt werden.

Ferner erweist es sich als vorteilhaft, wenn die Leistungseinheit zu einer H-Brückenschaltung elektrisch verschaltete Halbleiterschalter aufweist, wobei die mindestens eine Kompensationswicklung elektrisch im Querzweig der H-Brückenschaltung angeordnet ist, da dann die Leistungseinheit besonderes einfach realisiert werden kann.

Weiterhin erweist es sich als vorteilhaft, wenn die zu einer H-Brückenschaltung elektrisch verschalteten Halbleiterschalter der Leistungseinheit pulsweitenmoduliert von der Regeleinrichtung ansteuert werden, da hierdurch ein besonders energieeffizienter Betrieb der Strommesseinrichtung erzielt wird.

Ferner erweist es sich als vorteilhaft, wenn die Spannungserzeugungseinrichtung als elektrischer Widerstand ausgebildet ist durch den zumindest näherungsweise der Kompensationsstrom fließt, da dies eine besonders einfache und zuverlässige Ausbildung der Spannungserzeugungseinrichtung darstellt.

In diesem Zusammenhang erweist es sich als vorteilhaft, wenn dem elektrischen Widerstand ein Kondensator elektrisch parallel geschaltet ist, da hierdurch die Welligkeit der vom elektrischen Widerstand erzeugten ersten Spannung reduziert wird.

Weiterhin erweist es sich als vorteilhaft, wenn die

Kompensationsstromreduktionseinrichtung einen Differenzverstärker und ein Stellglied aufweist, wobei der Differenzverstärker dazu ausgebildet ist, die erste Spannung mit der Referenzspannung zu vergleichen und falls die erste Spannung die Referenzspannung übersteigt auf das Stellglied derart einzuwirken, dass das Stellglied die Steuerspannungen der im oberen Zweig der H-Brückenschaltung elektrisch angeordneten Halbleiterschalter und/oder die Steuerspannungen der im unteren Zweig der H-Brückenschaltung elektrisch angeordneten Halbleiterschalter reduziert. Hierdurch wird eine besonders einfach aufgebaute Kompensationsstromreduktionseinrichtung geschaffen.

Es erweist sich weiterhin als vorteilhaft, wenn die erste Spannung mit einer Referenzspannung verglichen wird und falls die erste Spannung die Referenzspannung übersteigt, dass die Höhe des Kompensationsstroms auf einen derartigen Wert reduziert wird, dass die erste Spannung der Referenzspannung entspricht. Hierdurch kann die maximale Höhe des Kompensationsstroms eingestellt werden.

Ferner erweist sich ein Leitungshalbleitermodul mit einem Substrat auf dem Leitungshalbleiterschalter angeordnet sind, wobei das Leitungshalbleitermodul Treiber aufweist, die zur Ansteuerung der Leitungshalbleiterschalter ausgebildet sind und eine erfindungsgemäße Strommesseinrichtung aufweist, wobei das Leitungshalbleitermodul eine elektrische Energieversorgungeinrichtung aufweist, die zur elektrischen Energieversorgung der Treiber und der Strommesseinrichtung ausgebildet ist, als vorteilhaft, da ein solches Leistungshalbleitermodul eine besonderes hohe Zuverlässigkeit aufweist.

Ein Ausführungsbeispiel der Erfindung ist in den Figuren dargestellt und wird im Folgenden näher erläutert. Dabei zeigen:
- FIG 1: ein schematisiertes elektrisches Schaltbild einer erfindungsgemäßen Strommesseinrichtung,
- FIG 2: eine Energieversorgungeinrichtung,
- FIG 3: ein schematisierte perspektive Darstellung eines Leitungshalbleitermoduls und
- FIG 4: eine schematisierte Schnittdarstellung eines Leitungshalbleitermoduls.

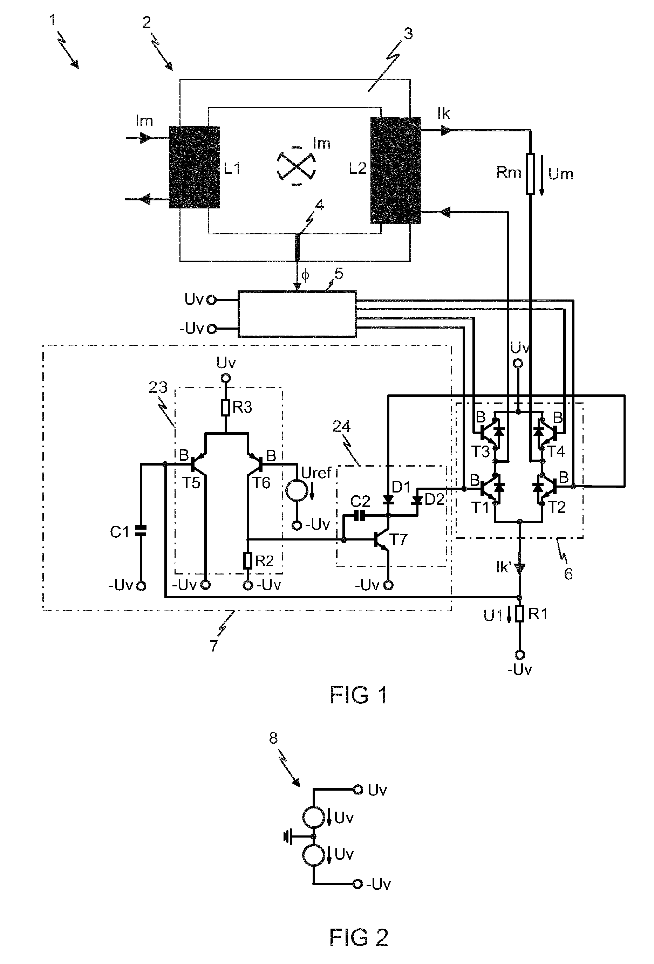

In FIG 1 ist ein schematisiertes elektrisches Schaltbild einer erfindungsgemäßen Strommesseinrichtung 1 dargestellt. In FIG 2 ist eine elektrische Energieversorgungeinrichtung 8 dargestellt, die die Strommesseinrichtung 1 mit elektrischer Energie versorgt und hierzu die beiden auf Masse bezogenen elektrischen Versorgungsspannungen Uv und -Uv mittels zweier Spannungsquellen, die jeweils eine Spannung Uv erzeugen, erzeugt. Beim Ausführungsbeispiel beträgt die Versorgungsspannung Uv = 15 V und die Versorgungsspannung -Uv = -15 V. Die Energieversorgungeinrichtung 8 ist mit der erfindungsgemäßen Strommesseinrichtung 1 an den in FIG 1 dargestellten Anschlusspunkten elektrisch leitend verbunden.

Die erfindungsgemäße Strommesseinrichtung 1 weist im Rahmen des Ausführungsbeispiels einen Kompensationsstromwandler 2, der einen magnetisch leitfähigen Kern 3 und eine um den Kern 3 verlaufende Messwicklung L1 und eine um den Kern 3 verlaufende Kompensationswicklung L2, sowie eine Regeleinrichtung 5 und eine von der Regeleinrichtung 5 angesteuerte Leistungseinheit 6 aufweist, auf. Der Kern 3 kann z.B. in Form eines Eisenlegierungsbleche aufweisenden Kerns oder als Ferritkern ausgebildet sein. Die Messwicklung L1, erzeugt, wenn ein zu messender Strom Im durch die Messwicklung L1 fließt, einen durch den Kern 3 verlaufenden magnetischen Messfluss.

Alternativ hierzu kann der Kompensationsstromwandler 2 auch derart ausgebildet sein, dass anstatt der Verwendung mindestens einer Messwicklung zur Erzeugung des magnetischen Messflusses, der magnetisch leitfähige Kern 3 um die elektrische Leitung angeordnet ist, durch den der zu messende Strom Im fließt, was in FIG 1 gestrichelt dargestellt ist.

In beiden Ausführungsvarianten des Kompensationsstromwandlers 2 bewirkt der zu messende Strom Im einen durch den Kern 3 verlaufenden magnetischen Messfluss.

Die Leistungseinheit 6 erzeugt einen durch die Kompensationswicklung L2 fließenden Kompensationsstrom Ik, wobei die Regeleinrichtung 5 die Leistungseinheit 6 derart ansteuert, dass ein beim Fließen des Kompensationsstroms Ik von der Kompensationswicklung L2 erzeugter, durch den Kern 3 verlaufender, magnetischer Kompensationsfluss genauso groß ist aber in entgegengesetzte Richtung durch den Kern 3 verläuft wie der magnetische Messfluss. Der durch den Kern 3 verlaufende magnetische Gesamtfluss φ wird mittels eines Sensors 4 gemessen und mittels der Regeleinrichtung 5 und der Leistungseinheit 6 durch Steuerung des Kompensationsstrom Ik auf eine Wert von Null geregelt. Der Sensor 4 kann z.B. in Form eines Hall-Sensors oder in Form eines weichmagnetischen Sensors vorliegen. Das Verhältnis des Kompensationsstroms Ik zum Messstrom Im wird durch das Verhältnis der Anzahl der Windungen der Messwicklung L1 zur Anzahl der Windungen Kompensationswicklung L2 bestimmt. Mittels eines elektrischen Messwiderstands Rm, durch den der Kompensationsstrom Ik fließt, wird eine dem Kompensationsstrom Ik proportionale Messspannung Um als Ausgangsgröße, z.B. zur Steuerung eines Leistungshalbleitermoduls, erzeugt. Es sei dabei an dieser Stelle angemerkt, dass im Rahmen des Ausführungsbeispiels der Kompensationsstromwandler 2 nur eine einzelne Kompensationswicklung L2 aufweist, der Kompensationsstromwandler 2 aber auch mehrere um den Kern verlaufende Kompensationswicklungen aufweisen kann. Weiterhin sei angemerkt, dass im Rahmen des Ausführungsbeispiels der Kompensationsstromwandler 2 nur eine einzelne Messwicklung L1 aufweist, der Kompensationsstromwandler 2 aber auch mehrere um den Kern verlaufende Messwicklungen aufweisen kann.

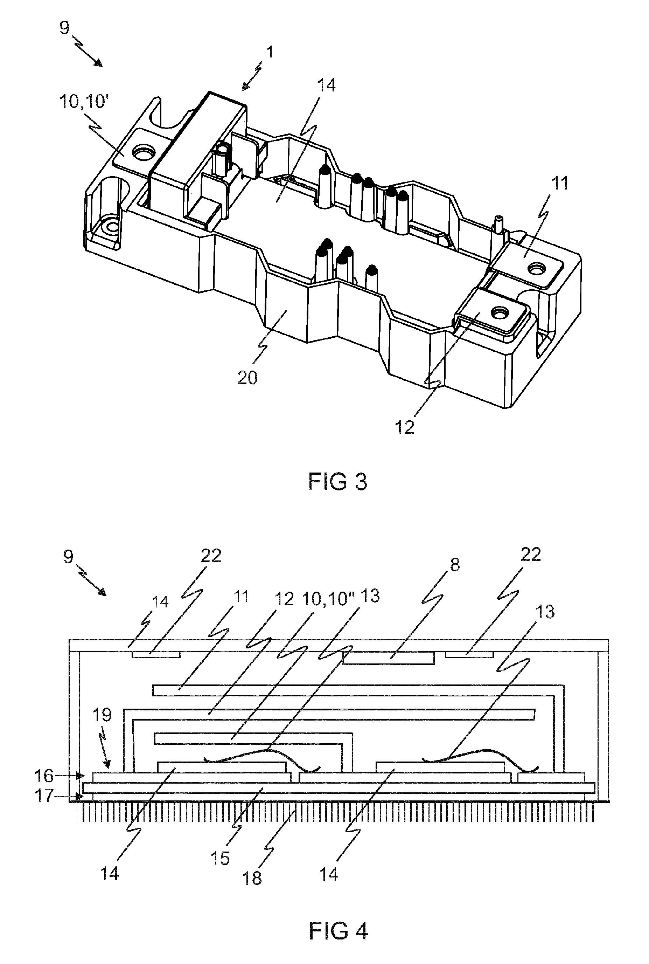

Im Rahmen des Ausführungsbeispiels weist das Leitungshalbleitermodul 9 die erfindungsgemäße Strommesseinrichtung 1 auf, die als zu messenden Strom Im, den Strom durch das Lastanschlusselement 10 misst (siehe FIG 3).

Die Leistungseinheit 6 weist vorzugsweise eine ersten Transistor T1, einen zweiten Transistor T2, einen dritten Transistor T3 und einen vierten Transistor T4 auf, wobei die Transistoren T1, T2, T3 und T4 zu einer H-Brückenschaltung elektrisch verschalteten sind und die Kompensationswicklung L2 elektrisch im Querzweig der H-Brückenschaltung angeordnet ist. Die Transistoren T1, T2, T3 und T4 der Leistungseinheit 6 werden dabei zur Erzeugung des Kompensationsstroms Ik vorzugsweise pulsweitenmoduliert angesteuert. Zur Bildung der H-Brückenschaltung ist im Ausführungsbeispiel der Emitter des dritten Transistors T3 mit dem Kollektor des ersten Transistors T1, und der Emitter des vierten Transistors T4 mit dem Kollektor des zweiten Transistors T2, und der Kollektor des dritten Transistors T3 mit dem Kollektor des vierten Transistors T4, und der Emitter des ersten Transistors T1 mit dem Emitter des zweiten Transistors T2 elektrisch verbunden. Die elektrische Verbindung vom Emitter des dritten Transistors T3 zum Emitter des vierten Transistors T4 bildet den Querzweig der H-Brückenschaltung, wobei die Kompensationswicklung L2 elektrisch im Querzweig der H-Brückenschaltung angeordnet ist. Der Messwiderstand Rm ist elektrisch in Reihe zur Kompensationswicklung L2 geschaltet und somit ebenfalls im Querzweig der H-Brückenschaltung angeordnet. Weiterhin ist vorzugsweise, wie in FIG 1 dargestellt, jedem der Transistoren T1, T2, T3 und T4 eine Freilaufdiode elektrisch antiparallel geschaltet. Gegebenenfalls können die Transistoren T1, T2, T3 und T4, z.B. zum Schutz vor elektrischen Überspannungen, mit Entlastungsschaltungen elektrisch verbunden sein, was in FIG 1 nicht dargestellt ist.

Weiterhin weist die Strommesseinrichtung 1 eine Spannungserzeugungseinrichtung, die dazu ausgebildet ist eine zur Höhe des Kompensationsstroms Ik zumindest näherungsweise korrespondierende und im Idealfall zur Höhe des Kompensationsstroms Ik korrespondierende, elektrische erste Spannung U1 zu erzeugen, auf. Im Rahmen des Ausführungsbeispiels ist die Spannungserzeugungseinrichtung als elektrischer Widerstand ausgebildet, d.h. die Spannungserzeugungseinrichtung liegt in Form des ersten elektrischen Widerstands R1 vor, wobei über dem ersten elektrischen Widerstand R1 die erste Spannung U1 abfällt. Der durch den ersten elektrischen Widerstands R1 fließende Strom Ik' entspricht zumindest näherungsweise dem Kompensationsstroms Ik und entspricht im Idealfall dem Kompensationsstroms Ik, so dass die elektrische erste Spannung U1 zumindest näherungsweise zur Höhe des Kompensationsstroms korrespondiert und im Idealfall zur Höhe des Kompensationsstroms korrespondiert. Dadurch, dass z.B. im Falle der Verwendung von konventionellen bipolaren Transistoren für die H-Brückenschaltung durch die Steueranschlüsse B (Basis) der Transistoren T1, T2, T3 und T4 geringe Steuerströme zu den Emittern der Transistoren fließen und im Falle der Verwendung von Entlastungschaltungen gegen Überspannungen zum Schutz der Transistoren, sowie bei Kommutierungsvorgängen, kann es zu Abweichungen zwischen dem Kompensationsstroms Ik und dem Strom Ik' kommen, wobei der Strom Ik' zumindest näherungsweise dem Kompensationsstroms Ik entspricht. Im Idealfall entspricht der Strom Ik'dem Kompensationsstroms Ik. Die eventuell vorhandenen Abweichungen zwischen dem Kompensationsstroms Ik und dem durch den ersten elektrischen Widerstand R1 fließenden Stroms Ik' können in Bezug auf die Erfindung vernachlässigt werden. Es sei an dieser Stelle angemerkt, dass anstatt der Verwendung von konventionellen bipolaren Transistoren als Halbleiterschalter für die H-Brückenschaltung z.B. auch IGBTs oder MOSFETs als Halbleiterschalter für die H-Brückenschaltung verwendet werden können und somit die von den Steueranschlüssen der Transistoren T1, T2, T3 und T4 zu den Emittern der Transistoren T1, T2, T3 und T4 fließenden Steuerströme vermieden werden können.

Weiterhin weist die Strommesseinrichtung 1 eine Kompensationsstromreduktionseinrichtung 7 auf, die dazu ausgebildet ist, die erste Spannung U1 mit einer Referenzspannung Uref zu vergleichen und falls die erste Spannung U1 die Referenzspannung Uref übersteigt auf die Leistungseinheit 6 derart einzuwirken, dass die Höhe des Kompensationsstroms Ik reduziert wird. Eine Zerstörung oder Beschädigung der Leistungseinheit 6 und/oder eine Überlastung der Energieversorgungeinrichtung 8 kann somit vermieden werden, Vorzugsweise wird dabei die Höhe des Kompensationsstroms Ik auf einen derartigen Wert reduziert, dass die erste Spannung U1 der Referenzspannung Uref entspricht. Durch entsprechende Wahl der Höhe der Referenzspannung Uref lässt sich somit einstellen wie hoch der Kompensationsstroms Ik maximal werden kann und somit die elektrische Leistungsaufnahme der Strommesseinrichtung 1 auf einen Maximalwert begrenzen, so dass die Energieversorgungeinrichtung 8 im Falle eines sehr hohen zu messenden Stroms Im nicht überlastet wird und/oder die Leistungseinheit 6 zerstört oder beschädigt wird.

Die Kompensationsstromreduktionseinrichtung 7 weist vorzugsweise einen Differenzverstärker 23 und ein Stellglied 24 auf, wobei der Differenzverstärker 23 dazu ausgebildet ist, die erste Spannung U1 mit der Referenzspannung Uref zu vergleichen und falls die erste Spannung U1 die Referenzspannung Uref übersteigt auf das Stellglied 24 derart einzuwirken, dass das Stellglied 24 die zwischen Basis und Emitter anliegenden Steuerspannungen der im oberen Zweig der H-Brückenschaltung elektrisch angeordneten Transistoren T3 und T4 und/oder die zwischen Basis und Emitter anliegenden Steuerspannungen der im unteren Zweig der H-Brückenschaltung elektrisch angeordneten Transistoren T1 und T2 reduziert. Beim Ausführungsbeispiel gemäß FIG 1 werden die Steuerspannungen der im unteren Zweig der H-Brückenschaltung elektrisch angeordneten Transistoren T1 und T2 reduziert. Überschreitet die an der Basis bzw. dem Gate in Bezug zum Emitter des betreffenden Transistors anliegende Steuerspannung des Transistors einen bestimmten Wert, dann geht der Transistor in seinen leitenden Zustand über, d.h. es fängt ein merklicher elektrischer Strom durch den Kollektor des Transistors an zu fließen. Beim Ausführungsbeispiel liegen die Steuerspannungen der Transistoren T1 und T2 in Form der zwischen der Basis B und Emitter des jeweiligen Transistors T1 bzw. T2 jeweilig anliegenden elektrischen Spannung vor.

Der vorzugsweise vorhandene erste Kondensator C1 reduziert die Welligkeit der ersten Spannung U1.

Der Differenzverstärker 23 weist im Rahmen des Ausführungsbeispiels einen fünften Transistor T5 und einen sechsten Transistor T6, sowie einen zweiten elektrischen Widerstand R2 und einen dritten elektrischen Widerstand R3 auf, die, wie in FIG 1 dargestellt, elektrisch verschalten sind. Der dritte Widerstand R3 begrenzt die durch die Transistoren T5 und T6 fließenden elektrischen Ströme. Sobald die erste Spannung U1 größer ist als die Referenzspannung Uref reduziert sich der durch den Kollektor des fünften Transistors T5 fließende elektrische Strom und der durch den Kollektor des sechsten Transistors T6 fließende elektrische Strom vergrößert sich, so dass sich die über dem zweiten Widerstand R2 anliegende elektrische Spannung vergrößert.

Das Stellglied 24 weist im Rahmen des Ausführungsbeispiels einen siebten Transistor, T7, einen zweiten Kondensator C2, sowie eine erste Diode D1 und eine zweite Diode D2 auf. Überschreitet die über dem zweiten Widerstand R2 anliegende elektrische Spannung einen bestimmten Wert, dann geht der siebte Transistor T7 in seinen leitenden Zustand über und es fließt ein elektrischer Strom durch den Kollektor des siebten Transistors T7, wodurch die Steuerspannungen des ersten und zweiten Transistors T1 und T2 reduziert werden und sich infolge der jeweilige elektrische Widerstand der Transistoren T1 und T2 erhöht und somit der Kompensationsstroms Ik reduziert wird. Der Kompensationsstroms Ik wird solchermaßen mittels der Kompensationsstromreduktionseinrichtung 7 begrenzt. Die erste und zweite Diode D1 und D2 entkoppeln in einer Stromrichtung den siebten Transistor T7 von der Basis des ersten und zweiten Transistors T1 und T2. Der zweite Kondensator C2 erhöht die Stabilität der durch die Kompensationsstromreduktionseinrichtung 7, durch den ersten und zweiten Transistors T1 und T2 und durch den ersten Widerstand R1 gebildete Regelschleife.

In FIG 3 ist eine schematisierte perspektive Darstellung und in FIG 4 eine Schnittdarstellung eines Leitungshalbleitermoduls 9 dargestellt. Das Leitungshalbleitermoduls 9 weist ein Substrat 19 auf. Das Substrat 19 weist einen Isolierstoffkörper 15 und eine auf einer ersten Seite des Isolierstoffkörpers 15 angeordnete und mit dem Isolierstoffkörper 15 verbundene elektrisch leitende strukturierte erste Leitungsschicht 16 auf, die Leiterbahnen ausbildet. Vorzugsweise weist das Substrat 19 eine elektrisch leitende, vorzugsweise unstrukturierte zweite Leitungsschicht 17 auf, wobei der Isolierstoffkörper 15 zwischen der strukturierten ersten Leitungsschicht 16 und der zweiten Leitungsschicht 17 angeordnet ist. Die strukturierte erste Leitungsschicht 16 des Substrats 2 kann z.B. aus Kupfer bestehen. Das Substrat kann z.B. wie beim Ausführungsbeispiel in Form eines DCB-Substrats oder in Form eines Insulated Metal Substrats vorliegen. Im Falle eines DCB-Substrats kann der Isolierstoffkörper 15 z.B. aus einer Keramik bestehen und die zweite Leitungsschicht 17 des ersten Substrats z.B. aus Kupfer bestehen. Im Falle eines Insulated Metal Substrats kann der Isolierstoffkörper 15 z.B. aus einer Schicht aus Polyimid oder Epoxy bestehen und die zweite Leitungsschicht 17 des Substrats aus einem Metallformkörper bestehen. Der Metallformkörper kann z.B. aus Aluminium oder einer Aluminiumlegierung bestehen.

Das Substrat 19 ist vorzugsweise mit einem Kühlkörper 18 oder mit einer Platte, welche zum thermischen Anbinden des Leitungshalbleitermoduls 9 an einen Kühlkörper dient, verbunden.

Auf dem Substrat 19 sind Leitungshalbleiterschalter 14 angeordnet. Die Leistungshalbleiterschalter können dabei z.B. in Form von Transistoren, wie z.B. IGBTs (Insulated Gate Bipolar Transistor) oder MOSFETs (Metal Oxide Semiconductor Field Effect Transistor), oder in Form von Thyristoren vorliegen. Die Leistungshalbleiterschalter 14 sind vorzugsweise mittels Bonddrähten 13 elektrisch leitend miteinander und mit elektrisch leitenden Lastanschlusselementen 10, 11 und 12 verbunden.

Im Rahmen des Ausführungsbeispiels weist das Leitungshalbleitermodul 9 die erfindungsgemäße Strommesseinrichtung 1 auf, die als zu messenden Strom Im, den Strom durch das Lastanschlusselement 10 misst. Beim Ausführungsbeispiel besteht das Lastanschlusselement 10 aus zwei Einzelelementen 10' und 10", wo das erste Einzelelement 10', welches beim Ausführungsbeispiel ein Loch zur Durchführung einer Schraube aufweist, in FIG 3 dargestellt ist und das zweite Einzelelement 10" des Lastanschlusselements 10 mit dem Substrat 19 verbunden ist, was in FIG 4 dargestellt ist. Zwischen den beiden Einzelelementen 10' und 10" des Lastanschlusselements 10 ist elektrisch die Messwicklung L1 der Strommesseinrichtung 1 geschalten, d.h. die beiden Einzelelementen 10' und 10" sind über die Messwicklung L1 elektrisch miteinander verbunden.

Das Leistungshalbleitermodul 9 weist zur Ansteuerung der Leitungshalbleiterschalter 14 Treiber 22 auf, die z.B. von einer, in den Figuren, da zum Verständnis der Erfindung unwesentlich, nicht dargestellten Steuerung erzeugte Ein- und Ausschaltsignale in entsprechende Ansteuersignale für die Leitungshalbleiterschalter 14 umsetzten. Der jeweilige Treiber ist dabei ausgangsseitig mit dem Steueranschluss (Basis bzw.Gate) des im zugeordneten Leitungshalbleiterschalters elektrisch verbunden, wobei die diesbezüglichen elektrischen Verbindungen der Übersichtlichkeit halber in FIG 4 nicht dargestellt sind.

Weiterhin weist das Leistungshalbleitermodul 9, eine elektrische Energieversorgungeinrichtung 8 (siehe auch FIG 2) auf, die zur elektrischen Energieversorgung der Strommesseinrichtung 1 und insbesondere im Rahmen des Ausführungsbeispiels gemäß FIG 3 und FIG 4 zusätzlich zur elektrischen Energieversorgung der Treiber 22 ausgebildet ist. Der Übersichtlichkeit halber sind die elektrischen Verbindungen zwischen Energieversorgungeinrichtung 8 und den Treibern 22 in FIG 4 nicht dargestellt.

Die Energieversorgungeinrichtung 8 und die Treiber 22 sind vorzugsweise auf einer Leiterplatte 14 angeordnet.

Weiterhin weist das Leistungshalbleitermodul 9 vorzugsweise ein Gehäuse 20 auf, das die Leitungshalbleiterschalter 14 lateral umschließt.

## Patentansprüche

1. Strommesseinrichtung umfassend:
• einen Kompensationsstromwandler (2), der einen magnetisch leitfähigen Kern (3) und mindestens eine um den Kern (3) verlaufende Kompensationswicklung (L2), sowie eine Regeleinrichtung (5) und eine von der Regeleinrichtung (5) angesteuerte Leistungseinheit (6) aufweist, wobei ein zu messender Strom (Im) einen durch den Kern (3) verlaufenden magnetischen Messfluss bewirkt, wobei die Leistungseinheit (6) einen durch die mindestens eine Kompensationswicklung (L2) fließenden Kompensationsstrom (Ik) erzeugt, wobei die Regeleinrichtung (5) die Leistungseinheit (6) derart ansteuert, dass ein beim Fließen des Kompensationsstroms (Ik) von der mindestens einen Kompensationswicklung (L2) erzeugter, durch den Kern (3) verlaufender, magnetischer Kompensationsfluss genauso groß ist aber in entgegengesetzte Richtung durch den Kern (3) verläuft wie der magnetische Messfluss,
• eine Spannungserzeugungseinrichtung (R1), die dazu ausgebildet ist eine zur Höhe des Kompensationsstroms (Ik) zumindest näherungsweise korrespondierende elektrische erste Spannung (U1) zu erzeugen, und
• eine Kompensationsstromreduktionseinrichtung (7), die dazu ausgebildet ist, die erste Spannung (U1) mit einer Referenzspannung (Uref) zu vergleichen und falls die erste Spannung (U1) die Referenzspannung (Uref) übersteigt auf die Leistungseinheit (6) derart einzuwirken, dass die Höhe des Kompensationsstroms (Ik) reduziert wird.

2. Strommesseinrichtung nach Anspruch 1, **dadurch gekennzeichnet, dass** die Kompensationsstromreduktionseinrichtung (7) dazu ausgebildet ist, die erste Spannung (U1) mit einer Referenzspannung (Uref) zu vergleichen und falls die erste Spannung (U1) die Referenzspannung (Uref) übersteigt auf die Leistungseinheit (6) derart einzuwirken, dass die Höhe des Kompensationsstroms (Ik) auf einen derartigen Wert reduziert wird, dass die erste Spannung (U1) der Referenzspannung (Uref) entspricht.

3. Strommesseinrichtung nach einem der vorhergehenden Ansprüche, **dadurch gekennzeichnet, dass** die Leistungseinheit (6) zu einer H-Brückenschaltung elektrisch verschaltete Halbleiterschalter (T1,T2,T3,T4) aufweist, wobei die mindestens eine Kompensationswicklung (L2) elektrisch im Querzweig der H-Brückenschaltung angeordnet ist.

4. Strommesseinrichtung nach Anspruch 3, **dadurch gekennzeichnet, dass** die zu einer H-Brückenschaltung elektrisch verschalteten Halbleiterschalter (T1,T2,T3,T4) der Leistungseinheit (6) pulsweitenmoduliert von der Regeleinrichtung (5) ansteuert werden.

5. Strommesseinrichtung nach einem der vorhergehenden Ansprüche, **dadurch gekennzeichnet, dass** die Spannungserzeugungseinrichtung (R1) als elektrischer Widerstand ausgebildet ist durch den zumindest näherungsweise der Kompensationsstrom (Ik) fließt.

6. Strommesseinrichtung nach Anspruch 5, **dadurch gekennzeichnet, dass** dem elektrischen Widerstand (R1) ein Kondensator (C1) elektrisch parallel geschaltet ist.

7. Strommesseinrichtung nach einem der Ansprüche 3 bis 6, **dadurch gekennzeichnet, dass** die Kompensationsstromreduktionseinrichtung (7) einen Differenzverstärker (23) und ein Stellglied (24) aufweist, wobei der Differenzverstärker (23) dazu ausgebildet ist, die erste Spannung (U1) mit der Referenzspannung (Uref) zu vergleichen und falls die erste Spannung (U1) die Referenzspannung (Uref) übersteigt auf das Stellglied (24) derart einzuwirken, dass das Stellglied (24) die Steuerspannungen der im oberen Zweig der H-Brückenschaltung elektrisch angeordneten Halbleiterschalter (T3,T4) und/oder die Steuerspannungen der im unteren Zweig der H-Brückenschaltung elektrisch angeordneten Halbleiterschalter (T1,T2) reduziert.

8. Leitungshalbleitermodul mit einem Substrat (19) auf dem Leitungshalbleiterschalter (14) angeordnet sind, wobei das Leitungshalbleitermodul (9) Treiber (22) aufweist, die zur Ansteuerung der Leitungshalbleiterschalter (14) ausgebildet sind und eine Strommesseinrichtung (1) nach einem der Ansprüche 1 bis 7 aufweist, wobei das Leitungshalbleitermodul (9) eine elektrische Energieversorgungeinrichtung (8) aufweist, die zur elektrischen Energieversorgung der Treiber (22) und der Strommesseinrichtung (1) ausgebildet ist.

9. Verfahren zum Betrieb einer Strommesseinrichtung,
• wobei die Strommesseinrichtung (1) einen Kompensationsstromwandler (2), der einen magnetisch leitfähigen Kern (3) und mindestens eine um den Kern (3) gewickelte Kompensationswicklung (L2), sowie eine Regeleinrichtung (5) und eine von der Regeleinrichtung (5) angesteuerte Leistungseinheit (6) aufweist,
• wobei von einem zu messenden Strom (Im), ein durch den Kern (3) verlaufender magnetischer Messfluss bewirkt wird,
• wobei von der Leistungseinheit (6) ein durch die mindestens eine Kompensationswicklung (L2) fließender Kompensationsstrom (Ik) erzeugt wird,
• wobei die Leistungseinheit (6) von der Regeleinrichtung (5) derart ansteuert wird, dass ein beim Fließen des Kompensationsstroms (Ik) von der mindestens einen Kompensationswicklung (L2) erzeugter, durch den Kern (3) verlaufender, magnetischer Kompensationsfluss genauso groß ist aber in entgegengesetzte Richtung durch den Kern (3) verläuft wie der magnetische Messfluss,
• wobei eine zur Höhe des Kompensationsstroms (Ik) zumindest näherungsweise korrespondierende elektrische erste Spannung (U1) erzeugt wird,
• wobei die erste Spannung (U1) mit einer Referenzspannung (Uref) verglichen wird und falls die erste Spannung (U1) die Referenzspannung (Uref) übersteigt die Höhe des Kompensationsstroms (Ik) reduziert wird.

10. Verfahren nach Anspruch 9, **dadurch gekennzeichnet, dass** die erste Spannung (U1) mit einer Referenzspannung (Uref) verglichen wird und falls die erste Spannung (U1) die Referenzspannung (Uref) übersteigt, die Höhe des Kompensationsstroms (Ik) auf einen derartigen Wert reduziert wird, dass die erste Spannung (U1) der Referenzspannung (Uref) entspricht.
